# EUROPÄISCHE PATENTSCHRIFT

(11) **EP 2 027 562 B1**
(45) Veröffentlichungstag und Bekanntmachung des Hinweises auf die Patenterteilung: **06.04.2016**
(21) Anmeldenummer: 07722438.4
(22) Anmeldetag: 16.05.2007
(51) Int. Cl.: B42D 25/30, B42D 25/40

(54) **VERFAHREN ZUM HERSTELLEN VON DOKUMENTEN MIT HOLOGRAMM SOWIE DOKUMENT MIT HOLOGRAMM**
METHOD FOR PRODUCTION OF DOCUMENTS WITH A HOLOGRAM AND A DOCUMENT WITH A HOLOGRAM
PROCÉDÉ DE PRODUCTION DE DOCUMENTS À HOLOGRAMME, ET DOCUMENT À HOLOGRAMME CORRESPONDANT

(30) Priorität: 16.05.2006 DE 102006023159
(43) Veröffentlichungstag der Anmeldung: 25.02.2009
(73) Patentinhaber: Hologram Industries Research GmbH, 85652 Pliening-Ottersberg (DE)
(72) Erfinder: DAUSMANN, Günther, 85630 Grasbrunn (DE); MENZ, Irina, 85630 Grasbrunn (DE)
(74) Vertreter: Farago, Peter Andreas
(86) Internationale Anmeldenummer: PCT/DE2007/000890
(87) Internationale Veröffentlichungsnummer: WO 2007/131496

(56) Entgegenhaltungen:
- EP-A- 0 563 931
- WO-A-02/11063
- WO-A-2004/005038
- WO-A-2005/091085
- DE-A1- 19 809 503
- US-A- 5 856 048

## Beschreibung

Die Erfindung bezieht sich auf ein Verfahren zum Herstellen von Dokumenten mit einem Hologramm sowie ein Dokument mit Hologramm gemäß Oberbegriff des Anspruch 1 bzw. 11, das insbesondere zur massenweisen Herstellung von Wert- und Sicherheitsdokumenten verwendbar bzw. geeignet ist, so von Personalausweisen, Reisepässen und Sicherheitsausweisen, mit personenabhängigen, individuellen, diffraktiven optischen Sicherheitselementen, wie z.B. holographischen Portraitaufnahmen.

Es ist bekannt, dass organische Quellmittel, wie z.B. Lösungsmittel, die mit Volumenhologrammen in Kontakt gebracht werden, den Beugungswirkungsgrad erhöhen und die Farbigkeit beeinflussen können. Durch Eindiffusion organischer Moleküle in das Volumenhologramm wird ein Schwellen und damit eine Abstandsänderung der holographischen Netzebenen verursacht, welches insbesondere für Reflexionsvolumenhologramme eine Farbvertiefung zur Folge hat (US 5,415,950). Allerdings ist es nicht möglich, mit Lösungsmittel nur partielle Teile des Hologramms zu schwellen, die neue sichtbare holographische Informationen darstellen. Dazu sind Quellmittel notwendig, deren Diffusionseigenschaften lokal gezielt variiert werden können. Monomerhaltige lichtaushärtbare Schichten erfüllen diese Anforderung (EP 0828203 A2, WO 95/13568).

Auf dieser Eigenschaft basiert auch das aus der DE 689 05 610 T2, WO 95/13568 bekannte Trockenfilm-Colortuningverfahren mittels eines Colortuningfilmes. Bei diesem wird auf ein Photopolymerhologramm der Colortuningfilm, bestehend aus einer monomerhaltigen Schicht mit einer Trägerfolie, laminiert, getempert und wieder vom Photopolymerfilm abgezogen. Durch den Temperprozess wandert Monomer in den Photopolymer und bewirkt in diesem Fall durch Schwellen einen vollflächigen Farbshift. Es kann auch partiell durch eine Maske belichtet, anschließend getempert und der Colortuningfilm wieder abgezogen werden. Die partiell belichteten Bereiche schwellen in diesem Fall nicht, da die Monomere in dem Colortuningfilm polymerisieren und nicht mehr diffundieren können. Auf diese Weise ist es möglich, individuelle Informationen nachträglich in den Photopolymer zu bringen. Allerdings ist nicht bekannt, individuelle Personendaten, wie beispielsweise ein Passfoto mittels Colortuningverfahrens zu erzeugen. Nachteilig dabei ist, neben der notwendigen langen Temperzeit von 30 Minuten, welche die relativ unbeweglichen Monomere des trockenen Colortuningfilmes zur Diffusion in das Hologramm benötigen, der zusätzliche Materialaufwand, verbunden mit großen anfallenden Abfallmengen und der zusätzliche Laminations- und Delaminationsprozess. Der Colortuningfilm kann nämlich aufgrund der zu geringen Verbundfestigkeit nicht als Oberflächenschutz für das Dokument auf der Hologrammoberfläche verbleiben und muss deshalb wieder delaminiert werden.

Für die massenweise Herstellung von Dokumenten ist bekannt, zunächst ein individuelles Volumenhologramm herzustellen, welches zusätzlich zu den individuellen Daten auch Standardinformationen aufweist, die von einem Hologrammaster kopiert wurden, und dieses Hologramm danach mit einem zugehörigen Dokument zu verkleben. Dabei kann das Volumenhologramm durch individuelle Laserbelichtung jedes einzelnen Sicherheitselements in einem Photomaterial erzeugt werden. Dies kann beispielsweise nach einem Verfahren, wie es aus der EP 0896260 A2 bekannt ist, erfolgen, mit dem diffraktive, volumenholographische, individuelle Sicherheitsmerkmale durch individuelle Laserbelichtung jedes einzelnen Sicherheitselements in dem Photomaterial massenweise hergestellt werden, welches dann später auf das dazugehörige Dokument appliziert wird. Für die richtige Zuordnung des individualisierten Hologramms zum entsprechenden Personaldokument ist dazu eine aufwendige Materiallogistik *mit* aufwendigem Datenabgleich notwendig. Nachteilig ist weiterhin, dass zwei verschiedene Laser eingesetzt werden müssen, um mit dem einen Laser Standarddaten zu kopieren und mit dem zweiten die individualisierten Daten zu belichten.

Ein Verfahren zum Hestellen von Dokumenten mit Hologramm ist auch aus der WO 02/11063 bekannt.

Der Erfindung liegt daher die **Aufgabe** zugrunde, ein kostengünstiges Verfahren für die Massenproduktion von Dokumenten mit einem Hologramm sowie ein Dokument mit Hologramm o. g. Gattung anzugeben, das individualisierte Hologramme mit neuen, visuell prüfbaren Echtheitsmerkmalen zur Verfügung stellt, die einen höheren Fälschungsschutz für Dokumente und Wertpapiere und ein hohes Sicherheitslevel des individuellen diffraktiven Sicherheitsmerkmals mit verbesserter Sichtbarkeit aufweisen.

Diese Aufgabe wird durch ein Verfahren mit den Merkmalen des Anspruch 1 gelöst. Vorteilhafte Ausgestaltungen ergeben sich aus den abhängigen Ansprüchen In der Beschreibung und den nachfolgenden Ansprüchen werden die Begriffe Photofolie und Photopolymerfilm alternativ als Begriffe für denselben Gegenstand verwendet. Dem gemäß erfolgt die Individualisierung der Hologramme während oder nach dem Verkleben mit einem Dokumententräger, z. B. einem gedruckten Personaldokument, oder der für den Dokumentoberflächenschutz notwendigen Oberflächenschutzfolie. Es können somit in Massenproduktion diffraktive optische Sicherheitselemente mit sich ständig änderndem Informationsgehalt hergestellt werden, ohne dass das Herstellverfahren durch den Steuerungsaufwand für die Zuordnung von Hologramm und Dokumententräger oder das Erfordernis verkompliziert wird, bei Fehlern die Dokumententräger und/oder Hologramme wieder in das Verfahren einzuschleusen. Durch das erfindungsgemäße Verfahren ist ein einfacherer Daten-Abgleich möglich und es können Material und Verfahrensschritte im Vergleich zum Stand der Technik eingespart werden. Des weiteren reduziert sich der Sicherheitsaufwand bei Lagerung oder Transport der holographischen Photofolie, wenn erst zu einem späteren Zeitpunkt oder an einem anderen Ort die Applikation auf das Dokument erfolgen soll, da die Photofolie noch keine sicherheitsrelevanten Personendaten trägt.

Erfündungsgemäß wird hierzu ein lichthärtbares, vorzugsweise monomerhaltiges Quellmittel verwendet, das in die holographische Photofolie mittels Maskenbelichtung partiell diffundieren und mit Licht ausgehärtet werden kann. Als Photofolie dient Photopolymer ein, unter dem auch volumenholographische Aufzeichnungsfilme beispielsweise auf Silberhalogenid Gelatinebasis zu verstehen sind.

Insbesondere ist von Vorteil, wenn die für die Dokumentapplikation ohnehin zu verwendenden Materialien, wie lichtaushärtbarer Klebstoff und/oder Oberflächenschutzlack, zur Erzeugung der individuellen holographischen Informationen unter Ausnutzung ihrer Colorshifteigenschaften zu nutzen. Der Material- und Prozessschrittaufwand ist dabei minimal, eine komplizierte Laserindividualisierung ist nicht notwendig und es können individuelle Informationen, wie beispielsweise das Passfoto, in hoher Qualität und mit Farbabstufungen erhalten werden.

In vorteilhafter Weise können weiterhin individuelle holographische Daten beim Verkleben mit dem Dokument und weitere zusätzliche Informationen beispielsweise während der Oberflächenschutzlackapplikation auf das applizierte Hologramm erzeugt werden, die sich in der Farbigkeit unterscheiden und damit zu einer weiteren Erhöhung des Sicherheitslevels der holographischen Merkmale führt.

Vorteilhafterweise werden die holographischen Standardelemente mit Laserlicht im blauen Wellenlängenbereich vom Master kopiert. Je kürzerwelliger die Laserwellenlänge bei der Belichtung des Hologramms ist, um so dichter liegen bekanntlich die Bragg'schen Netzebenen im Reflexionsvolumenhologramm und folglich ergeben sich mehr Möglichkeiten zu gezielten Abstufungen des Farbshifts nach längeren Wellenlängen durch chemisch verursachtes "Schwellen" bzw. Abstandsvergrößerung der Netzebenen.
Ebenso vereinfacht sich die Laserbelichtung der Hologramme im ersten Schritt. Es ist nämlich nur noch die Kopie der Standardhologrammdaten durchzuführen und keine Laserindividualisierung mehr, die zu Fehlern führen können. Zudem können mehrfarbige individuelle Hologramminformationen erzielt werden, obwohl nur mit einer Laserwellenlänge belichtet wird.
Des weiteren ergeben sich durch das erfindungsgemäße Verfahren Möglichkeiten für neue detektierbare holographische Sicherheitsmerkmale.

Erfindungsgemäß wird das Quellmittel nicht sofort ganzflächig mit Licht ausgehärtet, sondern zunächst durch eine informationstragende Graustufen-Maske partiell belichtet, z.B. durch eine LCD mit einer computererzeugten Graustufen-Maske. So bewirkt die Quellmittelschicht aufgrund ihres unterschiedlichen Aushärtungsgrades entsprechend den Graumaskenbereichen eine differenzierte Diffusion und lokal unterschiedliche Vergrößerung des Netzebenenabstands. Dadurch erfolgt auch der Farbshift individuell und für jeden Bildpunkt verschieden und ermöglicht dadurch eine gezielt angepasste Farbwiedergabe der Graustufeninformation. Das Bild der Grauwertinformation wird in ein Farbshiftbild umgesetzt. Erfindungsgemäß wird durch eine abschließende Belichtung bis zur vollständigen Aushärtung die weitere Diffusion eventuell noch vorhandenen Quellmittels nach einer Einwirkzeit gestoppt. Dadurch kann unter Verwendung nur eines Lasers ein mehrfarbiges Hologramm erzeugt werden. Dabei muss man für ein echtfarbig getuntes Bild die Eindringtiefe des Klebstoffes, d. h. die Anzahl der geschwollenen und der unveränderten Netzebenen berücksichtigen. Die Graustufenmaske muss rechnerisch so erstellt werden, dass bestimmte Graustufen die jeweils gewünschten Farbshifts ergeben, was für ein ausgewähltes Schwellmedium unter Berücksichtigung der Maskenbelichtungszeit realisierbar ist.

Wird die Graustufenmaske rechnerisch abhängig von einer bestimmten belichteten Ausgangsfarbe des Hologramms, die vorteilhafterweise im blauen Wellenlängenbereich ist, von dem ausgewählten Quellmittel, der ausgewählte Maskenbelichtungszeit und der Lichtintensität berechnet, so kann ein gewünschter Farbshift in den unterschiedlichen Graubereichen erzielt werden, der ein Echtfarbenbild ergibt, da alle Wellenlängen des sichtbaren Lichts erreichbar sind.

Erfindungsgemäß wird das Volumenhologramm durch Laserkopie von einem Masterhologramm, der neben der für die spätere Individualisierung vorgesehenen Hologrammfläche noch weitere holographische Standardelemente enthält, so belichtet, dass die Bragg'schen Ebenen unter einem Winkel, abweichend von 90° und 180°, bevorzugterweise unter flachem Winkel, also nicht parallel, zur Ebene der Photofolie angeordnet sind.
Durch das Quellen oder Schwellen der Photoschicht vergrößert sich deren Dicke und der Winkel der Bragg'schen Ebenen wird steiler. Dadurch entstehen Bereiche, in denen das Hologramm unter anderen Winkeln rekonstruiert und bei einem Verkippen einen besser sichtbaren Farbwechsel zeigt, wenn die ursprünglichen Bragg'schen Netzebenen im flachen Winkel zur Photofolie liegen. Diesen Kippeffekt kann man als Sicherheitsmerkmal zur Echtheitsbestimmung verwenden.

In vorteilhafter Ausführung ist die Quellmittelschicht zugleich die Klebeschicht zur Verklebung der Photofolie mit dem Dokument oder der zum langlebigen Oberflächenschutz des Dokumentes zu verwendenden Schutzfolie. Das Quellmittel kann aber auch der Schutzlack sein, der zur Oberflächenversiegelung des auf die Dokumentenoberfläche applizierten Hologramms dient.
Dadurch wird das Herstellverfahren einfacher und kostengünstiger, da die in jedem Fall erforderliche Klebeschicht oder Schutzlack diese Funktion der Quellmittelschicht gleichzeitig erfüllen kann. Hierzu kann ein monomerhaltiger Klebstoff oder Lack verwendet werden, der mit Licht ausgehärtet werden kann und eine große Klebkraft zwischen Photopolymer und Dokumententrägeroberfläche bzw. zum Photopolymer besitzt. Bevorzugt basiert der Klebstoff auf Urethanacrylat-Basis.

Dabei kann nach einem ersten Quellen durch die Klebeschicht als Quellmittel und deren Aushärten eine zweite Quellmittelschicht auf der anderen Seite der Photofolie aufgebracht werden und anschließend für einen definierten Zeitraum das Quellmittel der zweiten Quellmitteischicht in die Photofolie diffundieren, so dass die Photofolie erneut quillt und der Netzebenenabstand der Bragg'schen Netzebenen sich vergrößert. Schließlich wird durch vollständiges Belichten die weitere Diffusion des Quellmittels der zweiten Quellmittelschicht beendet.

Beispielsweise kann während des Aufklebens eines Photopolymerhologramms auf das Dokument mittels Maskenbelichtung eine individuelle Information erzeugt werden und nach vollständiger Klebstoffaushärtung die Hologrammträgerfolie, z. B. eine PET-Folie, abgezogen werden und die nun frei liegende andere Hologrammschichtseite mit einem UV-Lack versiegelt und damit vor Beschädigung geschützt werden. Die UV-Lackversiegelung ermöglicht eine weitere bildmäßige Belichtung mit anschließender vollständiger Belichtung, wodurch weitere Individualisierte Informationen oder eine weitere Farbänderung der bereits vorhandenen individuellen Informationen sowie der vom Master kopierten Standardelemente erreicht wird.

Durch das zweifache Individualisieren, einmal beim Aufkleben und schließlich beim Versiegeln, ist eine weitere Variationsvielfalt hinsichtlich der Echtfarbigkeit der individuellen Daten erreichbar. Dadurch sind, da mit zwei verschiedenen Quellmitteln unterschiedlicher Größe und Diffusionsgeschwindigkeit geschwollen wird, sich ergänzende Farbshifts erreichbar. Dabei können alle Verfahren, die beim ersten Quellen angewandt werden, beim zweiten Quellen ebenfalls verwendet werden.

Von Vorteil ist, wenn die Quellmittelschicht ein schnell diffundierendes Quellmittel enthält.
Da die Diffusion des Quellmittels von außen auf die Photofolie erfolgt, wird zunächst nur der Bereich der äußeren Bragg'schen Netzebenen des Hologramms geschwollen. Die tiefer liegenden Netzebenen bleiben in ihren Abständen unbeeinflusst. Bei einem schnell diffundierenden Quellmittel ergibt sich dabei eine scharfe Trennlinie zwischen geschwollenem und nicht geschwollenem Bereich. Dies bewirkt, dass die Bragg'schen Netzebenen zwei Winkel mit einem scharfen Knick als Übergang aufweisen. Bei Änderung des Betrachtungswinkels wird ein deutlicher Farbkippeffekt sichtbar, den man als visuell prüfbares und von Fälschern schwer nachzumachendes Sicherheitsmerkmal zur Echtheitsbestimmung verwenden kann. Dabei kann die Eindringtiefe wieder durch die Dauer der Belichtung, bzw. die Zeitdauer, während der ein Eindiffundieren ermöglicht wird, gesteuert werden.

Weiterhin können durch das erfindungsgemäße Verfahren weitere Muster oder Daten im nicht sichtbaren Spektralbereich erzeugt werden. Beispielsweise können bestimmte Hologrammbereiche durch zweifaches Schwellen so verändert werden, dass eine Rekonstruktion im Infrarotbereich erhalten wird, die als versteckte Sicherheitsmerkmale maschinell detektiert werden können.

Durch ein erfindungsgemäßes Dokument nach Anspruch 11 steht ein kostengünstig, in Massenfertigung herstellbares Dokument mit einem Hologramm als Sicherheitselement zur Verfügung.

Nachfolgend wird die Erfindung anhand mehreret Ausführungsbeispiele unter Bezug auf die Zeichnung näher erläutert.

Es zeigen:
- Fig. 1:: schematisch einen Ablauf eines erfindungsgemäßen Verfahrens in erster Ausführung,
- Fig. 2:: schematisch einen Ablauf eines erfindungsgemäßen Verfahrens in zweiter Ausführung,
- Fig. 3:: schematisch einen Ablauf eines erfindungsgemäßen Verfahrens in dritter Ausführung, und
- Fig. 4 und 5:: schematisch einen Ablauf eines erfindungsgemäßen Verfahrens in vier ter Ausführung.

Beim erfindungsgemäßen Verfahren, wird zunächst (nicht dargestellt) ein auf Rolle gewickelter Photopolymerfilm, bestehend aus eine photoempfindlichen Schicht und einem Filmträger, auf eine Mastertrommel laminiert, mit Laserlicht die Masterhologramme kopiert, die neben den holographischen Standardelementen mindestens ein holographisches Gitter mit Bragg'schen Netzebenen besitzen, die nicht parallel zur Masteroberfläche angeordnet sind. Sodann wird mit UV-Licht fixiert und gegebenenfalls getempert. Diese holographische Photofolie kann wieder aufgewickelt und bis zur Dokumentapplikation gelagert werden.

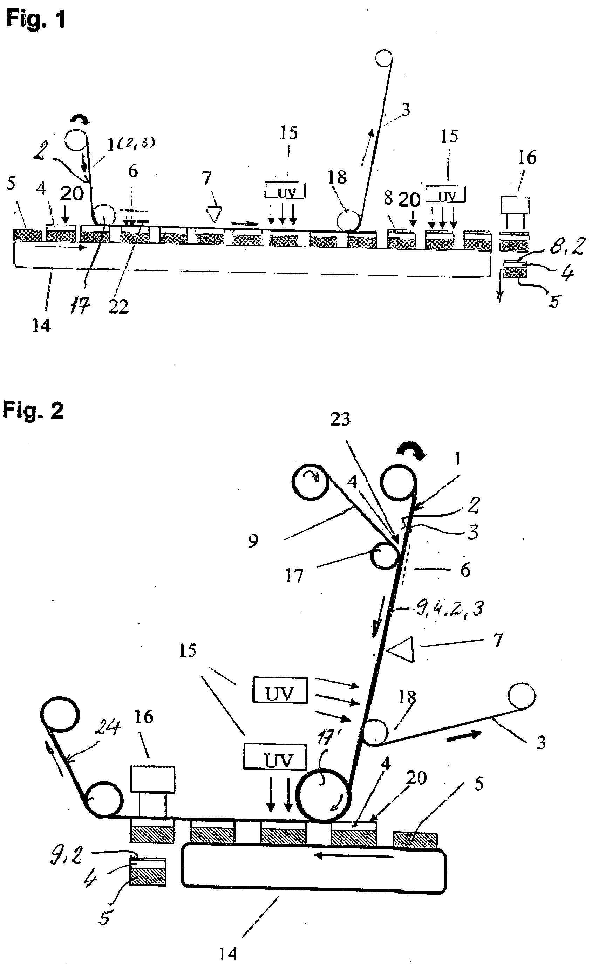

Wie in **Fig. 1** gezeigt, beginnt die Applikation und Individualisierung der Photofolie 1 nach dem erfindungsgemäßen Verfahren, mit dem Auftrag des lichthärtbaren, beispielsweise urethanacrylathaltigen Klebstoffes 4, bevorzugterweise durch Siebdruck 20 auf das personalisierte Dokument 5. Dann wird die Photofolie 1 wird mit der holographischen Schichtseite 2 auf das Dokument 5 laminiert mithilfe einer Laminierwalze 17, die Personaldaten gelesen und die LCD-Graustufenmaske 6 entsprechend den gelesenen Personaldaten erstellt. Danach erfolgt die erste Belichtung der Dokumentenoberfläche, bevorzugterweise mit Belichtungszeiten von 1-5 sec durch die LCD-Graustufenmaske 6, das Dokument wird weitertransportiert mithilfe eines Transportbandes 14 und währenddessen mit einem Farbdetektor 7 die einsetzende Farbshift gemessen. Nach Erreichen der gewünschten Farbshift wird der Klebstoffverbund, bevorzugterweise nach 30 sec bis 2 min, ganzflächig mit UV-Licht in einer Lichtaushärtestation 15 ausgehärtet. Danach wird der Filmträger 3 abgezogen über eine Abziehrolle 18 und die Hologrammoberfläche des Dokumentes mit einem lichthärtbaren Lack 8 nach dessen Aufbringung durch einen Siebdruck 20 zum Oberflächenlangzeitschutz versiegelt. Danach wird das Dokument in das Endformat gestanzt über eine Stanze 16. Man erhält damit ein Dokument mit einem oberflächengeschützten, individualisierten Volumenhologrammoverlay, in dem die individuellen holographischen Informationen 12, insbesondere das Passfoto, mehrfarbig und mit hohem Kontrast sichtbar ist.

Beim Ausführungsbeispiel nach **Fig. 2** wird die holographische Photofolie 1, deren Belichtung bereits im ersten Ausführungsbeispiel beschrieben ist, mit einem lichtaushärtbaren, urethanacrylathaltigen Klebstoff 4 beschichtet, beispielsweise mit der Rakeltechnik 23, dann wird eine kratzfeste transparente Schutzfolie 9, die letztlich zum Oberflächenschutz des Dokuments 5 dient, auflaminiert. Die Personaldaten des zugeführten Dokumentes werden gelesen, die LCD-Maske(6) erstellt, durch diese belichtet. Nach Erreichen der gewünschten Farbshift wird ganzflächig in der Lichtaushärtstation 15 lichtgehärtet und der Polymerfilmträger 3 mithilfe der Abziehrolle 18 abgezogen. Die Zeit zum Erreichen der gewünschten Farbshift kann durch Temperaturunterstützung auf wenige Sekunden verkürzt werden. Danach wird die individualisierte Photofolie auf das entsprechende Dokument mit lichthärtbarem Klebstoff 4 verklebt und das Dokument auf die Endformatgröße mithilfe einer Stanze16 ausgestanzt und der überstehende Folienrest aufgewickelt.

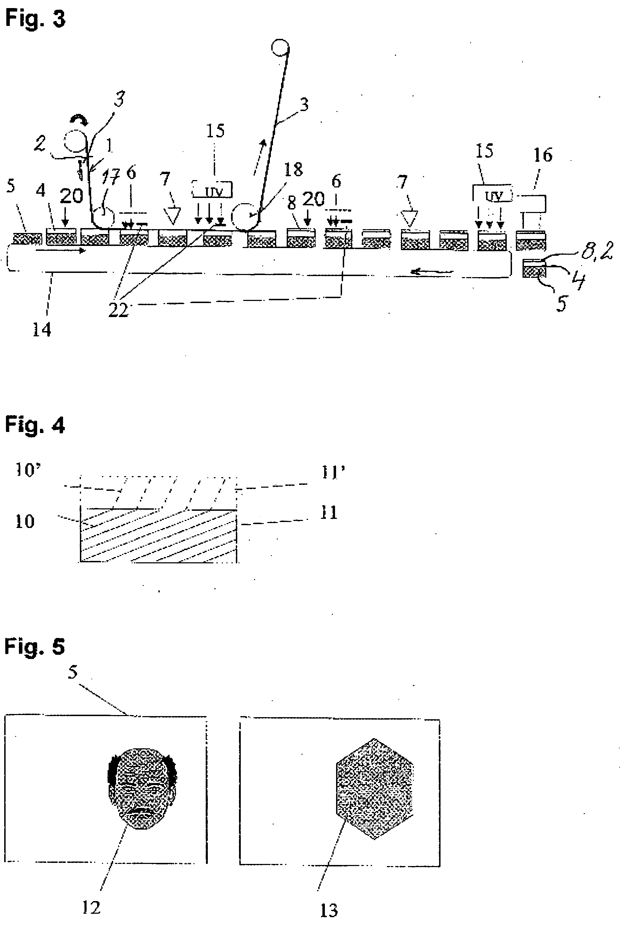

**Fig. 3** zeigt ein Ausführungsbeispiel, bei dem holographische Informationen von beiden Seiten der Photofolie während der Applikation auf das Dokuments erzeugt bzw. verändert werden.
So wird zunächst die holographische Photofolie 1 auf das mit Klebstoff 4 beschichtete Dokument 5 laminiert, durch eine die individuellen Daten tragende LCD-Maske 6, die ebenfalls z. B. Teilbereiche der holographischen Standardelemente abdeckt, belichtet. Nach Erreichen der gewünschten Farbshift, mit Ausnahme eines ausgewählten Bereiches, welcher durch eine Blende 2 abgedeckt ist, wird vollflächig in einer Lichtaushärtungsstation 15 ausgehärtet. Nach Abziehen der Trägerfolie 3 wird lichthärtbarer UV-Lack 8 auf die Hologrammschicht der applizierten Photofolie z. B im Siebdruckverfahren 20 aufgebracht, durch eine weitere LCD-Maskenbelichtung zusätzliche Informationen und oder zusätzliche Farbänderungen in die Photofolie eingebracht, bevor der UV-Lack durch vollflächige Belichtung versiegelt wird. Danach wird das Dokument durch die Stanze 16 auf das Endformat ausgeschnitten.

Man erhält ein Dokument mit einem holographischen Overlay, in welchem sowohl die holographischen Standardelemente als auch die eingebrachten individuellen Informationen in definiert unterschiedlichen Farben in einem Rekonstruktionswinkelbereich mit hoher Brillianz zu erkennen sind. Der bei der vollflächigen Klebstöffaushärtung durch die Blende 22 ausgesparte Hologrammbereich ist infolge der ununterbrochenen Shiftzeit bis zur abschließenden Oberflächenschutzlacklichtaushärtung visuell nicht mehr sichtbar, kann aber als verstecktes Sicherheitsmerkmal mit Infrarotlicht detektiert werden.

Zu **Fig. 4 und Fig. 5****,** die sich auf ein viertes Ausführungsbeispiel beziehen, ist anzumerken, daß zunächst vom Master die Masterhologramme mit Laserlicht der Wellenlänge 442 nm in einem Winkel von 30° in die Photofolie kopiert, fixiert, getempert und aufgewickelt werden. Dann wird die holographische Photofolie 1 wie unter Fig. 1 beschrieben, beim Verkleben mit dem Dokument 5 individualisiert, allerdings mit dem Unterschied, dass die Shiftzeit zwischen Maskenbelichtung und vollflächiger Lichtaushärtung um die Hälfte kürzer gewählt wurde. Dadurch wird ein deutlicher Kippeffekt der holographischen individuellen Informationen erreicht, d. h. diese Informationen sind nur unter einem Betrachtungswinkel sichtbar. In einem anderen Winkel wird das nicht geschwollene Hologramm in blauer Farbe, die der Laserkopierlichtwellenlänge entspricht, sichtbar. Es sind also zwei holographische Informationen übereinander vorhanden und getrennt und in verschiedenen Farben sichtbar.

**Fig. 4** zeigt schematisch im Querschnitt einen kleinen Bereich eines erfindungsgemäßen Hologramms. Dabei stellen die parallelen durchgezogenen Schraffur-Linien die Bragg'schen Netzebenen 10 vor dem Schwellen in der Hologrammschicht 11 dar und die gestrichelten Schraffur-Linien die Bragg-Ebenen 10' sowie die Hologrammgesamtdicke 11' nach dem Schwellen dar. Die infolge des Schwellprozesses veränderten Netzebenen 10' haben einen vergrößerten Abstand zueinander und der Winkel der Bragg'schen Netzebenen zur Ebene der Photofolie ist steiler geworden. Dies erklärt den beim Kippen des auf das Dokument applizierten Hologramms zu sehenden Farbwechseleffekt und die Möglichkeit, verschiedene Informationen separat zu erkennen. Dies kann als weiteres Sicherheitsmerkmal verwendet werden.

**Fig.5** zeigt ein Beispiel für die getrennte Sichtbarkeit der individuellen holographischen Information 12 in Form eines Portraits und ein 2D-Objekt 13, welches als Standardelement vom Master 14 kopiert wurde.

Generell kann die zur Hologrammindividualisierung verwendete Maske 6 auch drucktechnisch erzeugt werden, indem die Dokumentendaten ausgelesen werden und diese zu einem Tintenstrahldrucker geführt werden, der die Daten digital als Maske auf die Trägerfolie 3 oder auf die zu verklebende Folie 7 zum Dokumentenoberflächenschutz druckt. Vor der vollflächigen Lichtaushärtung muß diese Maske allerdings wieder entfernt werden.

### Bezugszeichenliste

- 1.: Photopolymerfolie (mit Reflexionsvolumenhologramm)
- 2.: holographische Schicht
- 3.: Trägerfolie (Polymer-)
- 4.: Klebstoff
- 5.: Dokument
- 6.: LCD-Graustufen-Maske
- 7.: Farbdetektor
- 8.: (Oberflächenschutz-) Lack
- 9.: (Oberflächen-) Schutzfolie
- 10.: Bragg'sche Netzebenen
- 11.: Hologrammschichtdicke
- 12.: Portrait (als individuelle holographische Information)
- 13.: 2D-Objekt (als holographisches Standardelement)
- 14.: Transportband
- 15.: Lichtaushärtungsstation
- 16.: Stanze
- 17.: Laminierwalzen
- 18.: Abziehrolle
- 19.: ----
- 20.: Siebdruck
- 21.: ----
- 22.: Blende
- 23.: Rackel
- 24.: Folienrest

## Patentansprüche

1. Verfahren zum Herstellen von Dokumenten mit Hologramm, bei dem in
- einem ersten Schritt ein Photopolymerfilm (1) bestehend aus einer photoempfindlichen Schicht (2) und einem Filmträger (3), mit Laserlicht Masterhologramme kopiert werden, die neben den holographischen Standardelementen mindestens ein holographisches Gitter mit Bragg'schen Netzebenen besitzen, die nicht parallel zur Master-Oberfläche angeordnet sind, wonach mit UV-Licht fixiert wird,
- und in einem zweiten Schritt der so mit mindestens einem Reflexionsvolumenhologramm versehene Photopolymerfilm (1) auf einen Dokumententräger (5) oder auf eine für den Oberflächenschutz des Dokuments vorgesehene transparente Schutzfolie (9) aufgeklebt wird,
**dadurch gekennzeichnet,**
**dass** im zweiten Schritt der holographische Photopolymerfilm (1) mit einem lichtaushärtbaren Quellmittel wie Klebstoff (4) oder Oberflächenschutzlack (8) in Kontakt gebracht und einer Maskenbelichtung (6) unterworfen wird, so dass die Hologrammindividualisierung während der Verklebung durch differenziertes Eindiffundieren des Quellmittels in den Photopolymerfilm(1) erfolgt, abhängig von der durch die Maske (6) verursachten Lichtmengenunterschiede,
und nach einem definierten Zeitraum die Quellung durch eine vollständige Belichtung (15) und somit ganzflächige Aufhärtung des Quelimittels beendet wird.

2. Verfahren nach Anspruch 1, **dadurch gekennzeichnet,**
**dass** mindestens ein Teilbereich der Photofolie im ersten Schritt mit Laserlicht im blauen Wellenlängenbereich belichtet wird.

3. Verfahren nach Anspruch 1, **dadurch gekennzeichnet,**
**dass** mindestens ein Bereich der Maske (6) unterschiedliche Lichtdurchlässigkeitsbereiche in Form der individuellen holographischen Information (12), insbesondere der Personaldaten und Passfoto, des zu applizierenden Dokumentes hat.

4. Verfahren nach den Ansprüchen 1 bis 3, **dadurch gekennzeichnet,**
**dass** eine partielle Belichtung durch eine informationstragende Graustufen-Maske (6) z. B. durch eine LCD mit einer computergesteuerten Graustufen-Maske, erfolgt.

5. Verfahren nach Anspruch 1, **dadurch gekennzeichnet,**
**dass** der als Quellmittel dienende lichtaushärtbare
Klebstoff (4) oder Oberflächenschutzlack (8) zum Verkleben des Photopolymerfilms mit dem Dokument, zum Verkleben mit der Oberflächenschutzfolie zum Dokumentenschutz oder zur Oberflächenschutzversiegelung des Dokumentes verwendet wird.

6. Verfahren nach Anspruch 1 bis 5, **dadurch gekennzeichnet,**
**dass** nach einem ersten Quellen des Photopolymerfilms (1), durch Einwirkung des für die Verklebung mit dem Dokument oder mit einer Folie zum Dokumentenoberflächenschutz verwendeten lichtaushärtbaren Klebstoffes(4) ein zweites Quellmittel (8, 4) auf der anderen Seite des Photopolymerfilms aufgebracht wird, partiell lichtgehärtet wird und somit differenziert in die Photofolie diffundieren kann, so dass die Photofolie erneut quillt und schließlich durch vollständiges Belichten die weitere Diffusion des zweiten Quellmittels beendet wird.

7. Verfahren nach einem der Ansprüche 1 bis 6, **dadurch gekennzeichnet,**
**dass** das jeweilige Quellmittel schnell diffundierend ist, insbesondere Monomere enthält.

8. Verfahren nach Ansprüchen 5 und 6, **dadurch gekennzeichnet,**
**dass** das zweite Quellmittel ebenfalls ein lichthärtender Klebstoff (4) oder Oberflächenschutzlack (8) sein kann und ebenfalls zunächst über eine informationstragende Graustufen-Maske (6) partiell belichtet und ausgehärtet wird und nach genau defniertem Zeitraum ganzflächig mit UV-Licht (15) ausgehärtet wird.

9. Verfahren nach einem der vorhergehenden Ansprüche
**dadurch gekennzeichnet,**
**dass** das auf das Dokument (5) applizierte Hologramm weitere Muster oder Daten im nicht sichtbaren Spektralbereich hat.

10. Verfahren nach einem der vorhergehenden Ansprüche,
**dadurch gekennzeichnet,**
**dass** das auf das Dokument applizierte Hologramm neben holographisch aufgezeichneten Standardelementen (13) individuelle Informationen (12) in unterschiedlichen Farben zeigt und die holographischen Informationen unter verschiedenen Betrachtungswinkeln zu erkennen sind

11. Dokument mit mindestens einem Hologramm, hergestellt nach einem der Verfahren gemäß Ansprüchen 1 bis 10 bei dem das auf das Dokument (5) applizierte Hologramm neben holographisch aufgezeichneten Standardelementen (13) individuelle Informationen (12) wie Passbild in unterschiedlichen Farben zeigt und die holographischen Informationen unter verschiedenen Betrachtungswinkeln erkennen lässt.

12. Dokument nach Anspruche 11, **dadurch gekennzeichnet,**
**dass** das auf dem Dokument (5) applizierte Hologramm weitere Muster oder Daten im nicht sichtbaren Spektralbereich hat.

## Claims

1. Method for producing documents with holograms, wherein in
- a first step, a Photopolymer film (1), consisting of a photosensitive layer (2) and a film carrier (3), master holograms are copied by laser light which possess in addition to the holographic standard elements at least one holographic grid with Bragg grid layers which are not arranged in parallel to the master surface, whereupon fixation by UV light takes place,
- and in a second step the photopolymer film (1) thus provided with at least one reflection volume hologram is glued onto a document carrier (5) or onto a transparent protective foil (9) provided for surface protection of the document,
**characterized in that**
in the second step, the holographic photopolymer film (1) is contacted with a swelling agent curable by light, such as an adhesive (4) or surface protection lacquer (8), and is exposed to mask photoexposure (6) so that hologram personalization during the gluing takes place by means of differentiated diffusion of the swelling agent into the photopolymer film (1), in dependence on the differences in light quantity caused by the mask (6),
and after a defined period, swelling is terminated by a complete photoexposure (15) and thus a curing of the swelling agent over the entire surface.

2. Method according to Claim 1, **characterized in that** during the first step, at least a part of the photo foil is exposed to laser light in the blue wavelength range.

3. Method according to Claim 1, **characterized in that** at least one part of the mask (6) has different light transmission portions in the form of the individual holographic information (12), in particular the personal data and passport photograph of the document to be applied.

4. Method according to Claims 1 through 3, **characterized in that** a partial exposure takes place through an information-carrying gray-level mask (6), e. g. through an LCD with a computer-controlled gray level mask.

5. Method according to Claim 1, **characterized in that** the adhesive (4) or surface protection lacquer (8) used as swelling agent and curable by light is used for adhering the photopolymer film to the document, for adhering to the surface-protection foil for the document protection or for the surface-protection sealing of the document.

6. Method according to Claims 1 through 5, **characterized in that** after a first swelling of the photopolymer film (1), by the effect of a light-curable adhesive (4) used for adhering to the document or to a foil for document surface protection, a second swelling agent (8, 4) is applied on the other side of the photopolymer film, is partially cured by light and thus can diffuse into the photo foil in a differentiated manner, so that the photo foil swells again and finally further diffusion of the second swelling agent is terminated by complete photoexposure.

7. Method according to one of Claims 1 through 6, **characterized in that** the respective swelling agent is quickly diffusing, in particular contains monomers.

8. Method according to Claims 5 and 6, **characterized in that** the second swelling agent also can be an adhesive (4) to be cured by light or a surface-protection lacquer (8) and is also first partially exposed to light and cured by means of an information-carrying gray-level mask (6) and is completely cured over its entire surface by UV light (15) after a precisely defined period of time.

9. Method according to one of the preceding claims, **characterized in that** the hologram applied on the document (5) has additional patterns or data in the non-visible spectral range.

10. Method according to one of the preceding claims, **characterized in that** the hologram applied on the document shows, in addition to holographically stored standard elements (13), individual information (12) in different colors, and **in that** the holographic information can be recognized from different viewing angles.

11. Document with at least one hologram, produced according to one of the methods according to Claims 1 through 10, wherein the hologram applied on the document (5) shows, in addition to holographically stored standard elements (13), individual information (12) such as a passport photograph in different colors and makes it possible to recognize the holographic information from different viewing angles.

12. Document according to Claim 11, **characterized in that** the hologram applied on the document (5) has additional patterns or data in the non-visible spectral range.

## Revendications

1. Procédé de réalisation de documents avec hologramme, dans lequel,
- dans une première étape, sur un film de photopolymère (1) composé d'une couche photosensible (2) et d'un support de film (3), sont copiés à la lumière laser des hologrammes maîtres qui, outre les éléments holographiques standards, possèdent au moins une grille holographique avec des plans de réseau de Bragg qui sont disposés non parallèlement à la surface du maître, puis on fixe à la lumière UV,
- et, dans une seconde étape, le film de photopolymère ainsi pourvu d'au moins un hologramme à volume de réflexion (1) est collé sur un support de document (5) ou sur un film protecteur transparent (9) prévu pour protéger la surface du document, **caractérisé en ce que**,
dans la seconde étape, le film de photopolymère holographique (1) est mis en contact avec un agent gonflant photodurcissable comme de la colle (4) ou une peinture protectrice de surface (8) et subit une exposition avec un masque (6), de sorte que l'individualisation de l'hologramme a lieu pendant le collage par diffusion différenciée de l'agent gonflant dans le film de photopolymère (1) en fonction des différences de quantité de lumière dues au masque (6) et que, après une durée déterminée, on met fin au gonflement par une exposition complète (15) et donc un durcissement sur toute la surface de l'agent gonflant.

2. Procédé selon la revendication 1,
**caractérisé en ce**
**qu'**au moins une partie du photofilm est exposée dans la première étape à la lumière laser dans la plage de longueur d'ondes bleue.

3. Procédé selon la revendication 1,
**caractérisé en ce**
**qu'**au moins une partie du masque (6) comporte différentes zones perméables à la lumière sous forme d'information graphique individuelle (12), en particulier de données personnelles et de photo d'identité du document à appliquer.

4. Procédé selon les revendications 1 à 3,
**caractérisé en ce**
**qu'**il y a une exposition partielle par un masque à degrés de gris comportant des informations (6), par exemple par un LCD avec un masque à degrés de gris commandé par ordinateur.

5. Procédé selon la revendication 1,
**caractérisé en ce que**,
la colle (4) photodurcissable servant d'agent gonflant ou la peinture protectrice de surface (8) est utilisée pour le collage du film photopolymère au document, pour le collage avec le film de protection de surface permettant de protéger le document ou pour l'isolation de protection de surface du document.

6. Procédé selon la revendication 1 à 5,
**caractérisé en ce que**,
après un premier gonflement du film de photopolymère (1), par action de la colle (4) photodurcissable utilisée pour le collage avec le document ou avec un film de protection de la surface du document, un second agent gonflant (8, 4) est appliqué sur l'autre face du film de photopolymère, partiellement thermodurci et peut ainsi se diffuser de manière différenciée dans le photofilm, de sorte que le photo film gonfle à nouveau et que la poursuite de la diffusion du second agent gonflant se termine enfin par une exposition complète.

7. Procédé selon une des revendications 1 à 6,
**caractérisé en ce que**
l'agent gonflant respectif se diffuse rapidement et contient en particulier des monomères.

8. Procédé selon les revendications 5 et 6,
**caractérisé en ce que**
le second agent gonflant peut également être une colle photodurcissable (4) ou une peinture protectrice de surface (8) et est d'abord également partiellement exposé à l'aide d'un masque à niveau de gris portant des informations (6) et est durci puis, après une durée précisément définie, est durci sur toute la surface à la lumière UV (15).

9. Procédé selon une des revendications précédentes,
**caractérisé en ce que**
l'hologramme appliqué sur le document (5) comporte d'autres motifs ou données dans la plage spectrale non visible.

10. Procédé selon une des revendications précédentes,
**caractérisé en ce que**
l'hologramme appliqué sur le document, outre des éléments standards enregistrés par hologramme (13), présente des informations individuelles (12) en différentes couleurs et que les informations holographiques sont détectables sous divers angles d'observation.

11. Document comportant au moins un hologramme, réalisé selon un des procédés selon les revendications 1 à 10, dans lequel l'hologramme appliqué sur le document (5) présente, outre des éléments standards enregistrés par hologramme (13) des informations individuelles (12) comme une photo d'identité dans différentes couleurs et laisse apparaître des informations holographiques sous divers angles d'observation.

12. Document selon la revendication 11,
**caractérisé en ce que**
l'hologramme appliqué sur le document (5) comporte d'autres motifs ou données dans la plage spectrale non visible.
